# EUROPEAN PATENT SPECIFICATION

(11) **EP 2 896 659 B1**
(45) Date of publication and mention of the grant of the patent: **15.08.2018**
(21) Application number: 13837933.4
(22) Date of filing: 05.09.2013
(51) Int. Cl.: C08L 101/00, B32B 15/08, C08K 3/22, C08K 7/14, C08L 77/06, C23C 18/20, C23C 18/30, H01Q 1/38, H05K 3/18, C23C 18/16, C23C 18/38, H01Q 1/24, C08J 5/04, C08K 9/02, C08G 69/26, C08L 53/02, H05K 3/10

(54) **THERMOPLASTIC RESIN COMPOSITION, RESIN MOLDED ARTICLE, AND METHOD FOR PRODUCING RESIN MOLDED ARTICLE HAVING A PLATED LAYER**
THERMOPLASTISCHE HARZZUSAMMENSETZUNG, HARZFORMARTIKEL UND VERFAHREN ZUR HERSTELLUNG DES HARZFORMARTIKELS MIT EINER PLATTIERTEN SCHICHT
COMPOSITION DE RÉSINE THERMOPLASTIQUE, ARTICLE MOULÉ EN RÉSINE, ET PROCÉDÉ DE FABRICATION D'UN ARTICLE MOULÉ EN RÉSINE PRÉSENTANT UNE COUCHE DE PLACAGE

(30) Priority: 14.09.2012 JP 2012203367
(43) Date of publication of application: 22.07.2015
(73) Proprietor: Mitsubishi Engineering-Plastics Corporation, Tokyo 105-0021 (JP)
(72) Inventor: TAKANO Takahiro, Hiratsuka-shi Kanagawa 254-0016 (JP); SUMINO Takahiko, Hiratsuka-shi Kanagawa 254-0016 (JP); ISHIHARA Kentarou, Hiratsuka-shi Kanagawa 254-0016 (JP); AKASHI Naohisa, Hiratsuka-shi Kanagawa 254-0016 (JP)
(74) Representative: Ishiguro, Masaoki
(86) International application number: PCT/JP2013/073951
(87) International publication number: WO 2014/042069

(56) References cited:
- WO-A1-2005/000969
- WO-A1-2012/128219
- WO-A1-2012/128219
- WO-A2-2009/141800
- JP-A- H0 881 639
- JP-A- H0 912 776
- JP-A- H10 500 149
- JP-A- 2004 534 408
- JP-A- 2006 124 701
- JP-A- 2007 055 110
- JP-A- 2008 201 050
- JP-A- 2010 274 530
- JP-A- 2010 536 947
- JP-B1- 5 340 513
- Christos C. Chamis: "Designing With Fiber-Reinforced Plastics (Planar Random Composites)", , 6 June 1982 (1982-06-06), XP055265148, Retrieved from the Internet: URL:http://ntrs.nasa.gov/archive/nasa/casi .ntrs.nasa.gov/19820016424.pdf [retrieved on 2016-04-13]

## Description

### TECHNICAL FIELD

The present invention relates to a thermoplastic resin composition. It also relates to resin a molded article obtained by molding the thermoplastic resin composition, and a method for manufacturing a resin molded article having a plated layer formed on the surface of the resin molded article.

### BACKGROUND ART

With recent development of cell phones including smartphones, various processes for manufacturing antennas inside the cell phones have been proposed. Especially, it would be desirable to provide a method for manufacturing an antenna that can be three-dimensionally designed in a cell phone. The laser direct structuring (hereinafter sometimes referred to as "LDS") technology has drawn attention as one of technologies for forming such three-dimensional antennas. The LDS technology refers to a technology for forming a plated layer by, for example, irradiating the surface of a resin molded article containing an LDS additive with a laser beam to activate only the region irradiated with the laser beam and applying a metal on the activated region. This technology is characterized in that metal structures such as antennas can be directly manufactured on the surface of resin substrates without using any adhesive or the like. The LDS technology is disclosed in, for example, patent documents 1 to 3 and the like. Further, WO2012/128219 discloses a thermoplastic resin composition which comprises a thermoplastic resin, inorganic fibers and a laser direct structuring additive, wherein the laser direct structuring additive comprises at least one component selected from copper, antimony and tin and the Mohs's hardness of the laser direct structuring additive is 1.5 or more smaller than that of the inorganic fibers. WO2012/128219 does not disclose copper-chromium oxide. Christos C. Chamis "Designing With Fiber-Reinforced Plastics (Planar Random Composites)", 6 June 1982, describes mechanical properties of molded thermoplastics. This document does not relate to an LDS process, and does not disclose copper-chromium oxide.

### REFERENCES

### PATENT DOCUMENTS

Patent document 1: JP-A2000-503817
Patent document 2: JP-A2004-534408
Patent document 3: International Publication WO2009/141800.

### SUMMARY OF THE INVENTION

### PROBLEMS TO BE SOLVED BY THE INVENTION

On the other hand, it would also be desirable to improve the mechanical strength of molded articles obtained by molding thermoplastic resin compositions. The same is true for resin compositions combining a thermoplastic resin with an LDS additive.

The present invention aims to solve the problems of the prior art described above, thereby providing thermoplastic resin compositions from which a resin molded article having high mechanical strength can be obtained while retaining the plating properties of the resin molded article.

### MEANS TO SOLVE THE PROBLEMS

Under these circumstances, as a result of the inventors careful studies, we achieved the present invention on the basis of the finding that the problems described above can be solved by adding a glass fiber comprising SiO₂ and Al₂O₃ in a proportion of 60 to 70 % by weight of SiO₂ and 20 to 30 % by weight of Al₂O₃ as an LDS additive to a thermoplastic resin. Specifically, the problems described above were solved by the following means <1>, preferably <2> to <14>.
<1> A thermoplastic resin composition comprising a thermoplastic resin, and 1 to 30 parts by weight of a laser direct structuring additive and 10 to 200 parts by weight of a glass fiber per 100 parts by weight of the thermoplastic resin, wherein the glass fiber comprises SiO₂ and Al₂O₃ in a proportion of 60 to 70 % by weight of SiO₂ and 20 to 30 % by weight of Al₂O₃, wherein the laser direct structuring additive comprises a copper-chromium oxide.
<2> The thermoplastic resin composition according to <1>, wherein the laser direct structuring additive has a Mohs hardness of 5.5 or more.
<3> The thermoplastic resin composition according to any one of <1> to <2>, wherein the glass fiber has a tensile modulus of elasticity of 80GPa or more.
<4> The thermoplastic resin composition according to any one of <1> to <3>, wherein the glass fiber comprises S-glass.
<5> The thermoplastic resin composition according to any one of <1> to <4>, wherein the thermoplastic resin is a polyamide resin.
<6> A resin molded article obtained by molding the thermoplastic resin composition according to any one of <1> to <5>.
<7> The resin molded article according to <6>, further comprising a plated layer on a surface.
<8> The resin molded article according to <6> or <7>, which is a part for portable electronic devices.
<9> The resin molded article according to <7> or <8>, wherein the plated layer has performance as an antenna.
<10> A method for manufacturing a resin molded article having a plated layer, comprising irradiating a surface of a resin molded article obtained by molding the thermoplastic resin composition according to any one of claims 1 to 5 with a laser beam, and then applying a metal to form a plated layer.
<11> The method for manufacturing a resin molded article having a plated layer according to <10>, wherein the plated layer is a copper plated layer.
<12> A method for manufacturing a part for portable electronic devices, comprising a method for manufacturing a resin molded article having a plated layer according to <10> or <11>.

### ADVANTAGES OF THE INVENTION

The present invention makes it possible to provide thermoplastic resin molded articles having high mechanical strength while retaining the plating properties of the resin molded articles.

### BRIEF EXPLANATION OF THE DRAWINGS

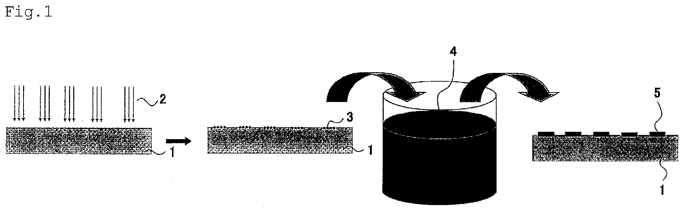

Figure 1 is a schematic diagram showing a process for plating the surface of a resin molded article.

### THE MOST PREFERRED EMBODIMENTS OF THE INVENTION

The present invention will be explained in detail below. As used herein, each numerical range expressed by two values on both sides of "to" is used to mean the range including the values indicated before and after "to" as lower and upper limits.

### <Thermoplastic resin compositions>

The thermoplastic resin composition of the present invention is characterized in that the thermoplastic resin composition comprises a thermoplastic resin, and 1 to 30 parts by weight of an LDS additive and 10 to 200 parts by weight of a glass fiber per 100 parts by weight of the thermoplastic resin, wherein the glass fiber comprises SiO₂ and Al₂O₃ in a proportion of 60 to 70 % by weight of SiO₂ and 20 to 30 % by weight of Al₂O_{3,} wherein the laser direct structuring additive comprises a copper-chromium oxide.

### <Thermoplastic resin>

The thermoplastic resin composition of the present invention comprises a thermoplastic resin. The type of the thermoplastic resin is not specifically limited, and examples include polycarbonate resins, alloys of polyphenylene ether resins and polystyrene resins, alloys of polyphenylene ether resins and polyamide resins, thermoplastic polyester resins, methyl methacrylate/acrylonitrile/butadiene/styrene copolymer resins, methyl methacrylate/styrene copolymer resins, methyl methacrylate resins, rubber-reinforced methyl methacrylate resins, polyamide resins, polyacetal resins, polylactic resins, polyolefin resins and the like.

In the present invention, polyamide resins and thermoplastic polyester resins are preferably used, more preferably polyamide resins . The thermoplastic resins may be used alone or as a combination of two or more of them.

Polyamide resins are polyamide polymers that contain an acid amide group (-CONH-) in the molecule and that can be melted by heating. Specifically, the polyamide resin includes various polyamide resins such as polycondensates of lactams, polycondensates of diamine compounds with dicarboxylic acid compounds, polycondensates of ω-aminocarboxylic acids and the like, or copolyamide resins or blends thereof and the like.

Lactams that can be polycondensed into polyamide resins include, for example, ε-caprolactam, ω-laurolactam and the like.

Diamine compounds include, for example, aliphatic, alicyclic and aromatic diamines such as tetramethylenediamine, hexamethylenediamine, undecamethylenediamine, dodecamethylenediamine, 2-methylpentamethylenediamine, 2,2,4- or 2,4,4-trimethylhexamethylenediamine, 5-methylnonamethylenediamine, m-xylylenediamine (MXDA), p-xylylenediamine, 1,3-bis(aminomethyl)cyclohexane, 1,4-bis(aminomethyl)cyclohexane, 1-amino-3-aminomethyl-3,5,5-trimethylcyclohexane, bis(4-aminocyclohexyl)methane, bis(3-methyl-4-aminocyclohexyl)methane, 2,2-bis(4-aminocyclohexyl)propane, bis(aminopropyl)piperazine, aminoethylpiperazine and the like.

Dicarboxylic acid compounds include, for example, aliphatic, alicyclic and aromatic dicarboxylic acids such as adipic acid, suberic acid, azelaic acid, sebacic acid, dodecanedioic acid, terephthalic acid, isophthalic acid, 2-chloroterephthalic acid, 2-methylterephthalic acid, 5-methylisophthalic acid, 5-sulfoisophthalic acid sodium salt, hexahydroterephthalic acid, hexahydroisophthalic acid and the like.

ω-Aminocarboxylic acids include, for example, amino acids such as 6-aminocaproic acid, 11-aminoundecanoic acid, 12-aminododecanoic acid, p-aminomethylbenzoic acid and the like.

Specific examples of polyamide resins obtained by polycondensing these materials include polyamide 4, polyamide 6, polyamide 11, polyamide 12, polyamide 46, polyamide 66, polyamide 610, polyamide 612, polyhexamethylene terephthalamide (polyamide 6T), polyhexamethylene isophthalamide (polyamide 6I), poly(m-xylylene adipamide) (polyamide MXD6), poly(m-xylylene dodecamide), polyamide 9T, polyamide 9MT and the like. In the present invention, these polyamide homopolymers or copolymers can be used alone or as a mixture thereof.

Among the polyamide resins described above, polyamide 6, polyamide 66, or xylylenediamine polyamide resins (MX nylons) obtained by polycondensation of straight-chain aliphatic α,ω-dibasic acids with xylylenediamines are more preferably used to improve moldability and heat resistance. Among them, MX nylons are more preferred to improve heat resistance and flame retardance. When the polyamide resins are used as a mixture, the proportion of MX nylons in the polyamide resins is preferably 50 % by weight or more, more preferably 80 % by weight or more.

MX nylons are preferably used in combination with aliphatic polyamide resins such as polyamide 66, polyamide 6, polyamide 46, polyamide 9T and the like to shorten the molding cycle because MX nylons crystallize somewhat more slowly than aliphatic polyamide resins. Aliphatic polyamide resins used to shorten the molding cycle include rapidly crystallizing polyamide resins such as polyamide 66, polyamide 6, polyamide 46, polyamide 9T and the like and polyamide resins having a high melting point such as polyamides 66/6T, 66/6T/6I and the like, among which polyamide 66 or polyamide 6 is preferred from an economic viewpoint. The aliphatic polyamide resins should preferably be contained at less than 50 % by weight of all polyamide resins to improve moldability and the balance between physical properties. Good heat resistance can be maintained by adding less than 50 % by weight of the aliphatic polyamide resins.

Straight-chain aliphatic α,ω-dibasic acids that can be preferably used as one raw material of MX nylons are straight-chain aliphatic α,ω-dibasic acids containing 6 to 20 carbon atoms such as adipic acid, sebacic acid, suberic acid, dodecanedioic acid, eicosadienoic acid and the like. Among these straight-chain aliphatic α,ω-dibasic acids, sebacic acid is especially preferred in terms of moldability, the balance among performances of molded articles and the like.

Xylylenediamines used as the other raw material of MX nylons include m-xylylenediamine or xylylenediamine mixtures of p-xylylenediamine and m-xylylenediamine. The molar ratio of m-xylylenediamine and p-xylylenediamine (m-xylylenediamine/p-xylylenediamine) in the xylylenediamine mixtures is preferably 55/45 to 100/0, more preferably 70/30 to 100/0. The molar proportion of p-xylylenediamine is preferably less than 45 mol% because the melting point of the polyamide resins can be kept low, which makes it easy to polymerize the MX nylons or to mold compositions containing the MX nylons.

Description about thermoplastic polyester resins can be found in paragraphs 0013 to 0016 of JP-A2010-174223. For example, polyester resins include a polybutylene terephthalate resin, or a mixture containing 60 % by weight or more, preferably 80 % by weight or more of a polybutylene terephthalate resin.

The amount of the thermoplastic resin contained in the thermoplastic resin composition of the present invention is preferably 40 % by weight or more, more preferably 45 % by weight or more in total.

### <LDS additive>

As used herein, the term "LDS additive" refers to a compound that allows a thermoplastic resin (for example, PAMP10 synthesized in the Examples described later) to be plated with a metal when 4 parts by weight of the compound as a possible LDS additive is added per 100 parts by weight of the resin and the resin is irradiated with a YAG laser beam having a wavelength of 1064 nm at an output power of 10 W, a frequency of 80 kHz, and a scanning speed of 3 m/s, and then subjected to a plating process to apply the metal on the surface irradiated with the laser beam in the electroless plating bath M-Copper 85 from MacDermid. The LDS additive used in the present invention may be synthesized or commercially available. In addition to commercially available products sold for use as LDS additives, those sold for other purposes may also be used so far as they meet the requirements for the LDS additive in the present invention. A single LDS additive may be used or two or more LDS additives may be used in combination.

The LDS additive used in the present invention is an oxide containing copper, preferably an oxide containing copper and chromium (a copper-chromium oxide), more preferably an oxide containing only copper and chromium as metal components. Such LDS additives include, for example, CuCr₂O₄ and Cu₃(PO₄)₂Cu(OH)₂, especially preferably CuCr₂O₄. When such an oxide containing copper is used as an LDS additive, the advantages of the present invention tend to be produced more effectively. The copper content in the LDS additive is preferably 20 to 95 % by mass.

In some compositions not according to the present invention, the LDS additive used preferably contains at least one of tin and antimony, more preferably both antimony and tin, even more preferably both antimony and tin wherein tin is present in excess of antimony, especially preferably both antimony and a tin oxide wherein tin is present in excess of antimony. Another preferred example of such compositions contains both an antimony oxide and a tin oxide wherein tin is present in excess of antimony.

The LDS additive used in the present invention preferably has a Mohs hardness of 5.5 or more, more preferably a Mohs hardness of 5.5 to 6.0. Contrary to the prediction that the use of such an LDS additive having a high Mohs hardness would damage inorganic fibers to decrease mechanical strength, high mechanical strength can be retained in the present invention even using such an LDS additive having a high Mohs hardness.

The LDS additive used in the present invention preferably has an average particle size of 0.01 to 50 µm, more preferably 0.05 to 30 µm. When the LDS additive has such an average particle size, the advantages of the present invention tend to be produced more effectively.

The amount of the LDS additive contained in the thermoplastic resin composition of the present invention should be 1 to 30 parts by weight, preferably 2 to 25 parts by weight, more preferably 5 to 20 parts by weight per 100 parts by weight of the thermoplastic resin. When the LDS additive is contained in an amount within such ranges, the plating properties of a resin molded article can be more improved. Further, plating can be achieved with smaller amounts by combining the LDS additive with talc as described later.

### <Glass fiber>

The thermoplastic resin composition of the present invention further comprises a glass fiber. The incorporation of a glass fiber can improve mechanical strength. In addition, the incorporation of a glass fiber can also further improve dimensional precision. A single type of glass fiber may be used or two or more types of glass fibers may be used in combination.

The glass fiber used in the present invention has a composition comprising SiO₂ and Al₂O₃ in a proportion of 60 to 70 % by weight of SiO₂ and 20 to 30 % by weight of Al₂O₃. Moreover, the glass fiber used in the present invention may further comprise B (boron) along with SiO₂ and Al₂O₃, in which case the B (boron) content is preferably 1 % by weight or less. Further, the glass fiber used in the present invention preferably has a tensile modulus of elasticity of 80GPa or more.

Specifically, an example of the glass fiber used in the present invention is S-glass (high strength glass) . The use of a glass fiber having such a composition can improve the mechanical strength (for example, flexural strength, flexural modulus of elasticity, Charpy impact strength (notched and unnotched) and the like) of a resin molded article obtained from the thermoplastic resin composition of the present invention while maintaining the plating properties of the resin molded article.

Conventionally, E-glass (electrical glass) has been used in thermoplastic resin composition, but our studies revealed that the mechanical strength of a resin molded article obtained by using E-glass was difficult to maintain at a high level. In contrast, high mechanical strength can be achieved while maintaining the plating properties in a resin molded article obtained by using a glass fiber according to the present invention comprising SiO₂ and Al₂O₃ in a proportion of 60 to 70 % by weight of SiO₂ and 20 to 30 % by weight of Al₂O₃.

Thus, an example of a preferred embodiment of the present invention includes an embodiment wherein the glass fiber substantially consists of the glass fiber comprising SiO₂ and Al₂O₃ in a proportion of 60 to 70 % by weight of SiO₂ and 20 to 30 % by weight of Al₂O₃.

The glass fiber used in the present invention may have been surface-treated with a silane coupling agent such as γ-methacryloxypropyltrimethoxysilane, γ-glycidoxypropyltrimethoxysilane, γ-aminopropyltriethoxysilane or the like. The amount of the silane coupling agent deposited is typically 0.01 to 1 % by weight based on the weight of the glass fiber. Further, the glass fiber may be used after the glass fiber has been surface-treated as appropriate with a lubricant such as a fatty acid amide compound, a silicone oil or the like; an antistatic agent such as a quaternary ammonium salt or the like; a resin having a film-coating ability such as an epoxy resin, a urethane resin or the like; or a mixture of a resin having a film-coating ability with a heat stabilizer or a flame retardant or the like.

The glass fiber used in the present invention preferably has an average diameter of 20 µm or less, more preferably 1 to 15 µm to further improve the balance among physical properties (strength, rigidity, rigidity after heating, impact strength) and to further reduce molding warpage. Further, glass fibers that are generally used often typically have a circular section, but the present invention is not specifically limited to such a sectional shape, and glass fibers having a cocoon-shaped, elliptical or rectangular section, for example, can also be used.

The glass fiber is not specifically limited to any length, and can be used by selecting it from long fiber bundles (rovings), short fiber bundles (chopped strands) and the like. Such glass fiber bundles are each preferably composed of 100 to 5000 fibers. Further, the glass fiber may be a milled strand known as so-called milled fiber or glass powder or a single continuous strand called sliver so far as the glass fiber has an average length of 0.1 mm or more in the thermoplastic resin composition after the thermoplastic resin composition has been kneaded.

The amount of the glass fiber contained in the thermoplastic resin composition of the present invention is typically 10 to 200 parts by weight, preferably 20 to 180 parts by weight, more preferably 30 to 150 parts by weight per 100 parts by weight of the thermoplastic resin.

In the present invention, other glass fibers (for example, E-glass and the like) may be contained in addition to the glass fiber comprising SiO₂ and Al₂O₃ in a proportion of 60 to 70 % by weight of SiO₂ and 20 to 30 % by weight of Al₂O₃. However, the other glass fibers should preferably be contained in an amount of 5 % by weight or less of the total amount of the glass fibers, preferably 3 % by weight or less. More preferably, the thermoplastic resin composition is substantially free from the other glass fibers, i.e., 0 % by weight. Further, the thermoplastic resin and the glass fibers preferably account for 70 % by weight or more of all components, more preferably 80 % by weight or more of all components in the thermoplastic resin composition of the present invention.

### <Elastomer>

The thermoplastic resin composition of the present invention may further comprise an elastomer. The incorporation of an elastomer can improve the impact resistance of the thermoplastic resin composition.

The elastomer used in the present invention is preferably a graft copolymer obtained by graft copolymerization of a rubber component with a monomer component that can be copolymerized with the rubber component. The graft copolymer may be prepared by any processes such as mass polymerization, solution polymerization, suspension polymerization, emulsion polymerization and the like, and may be prepared by single-stage or multistage graft copolymerization.

The rubber component typically has a glass transition temperature of 0 °C or less, preferably -20 °C or less, more preferably -30 °C or less. Specific examples of rubber components include polybutadiene rubbers; polyisoprene rubbers; poly(alkyl acrylate) rubbers such as poly(butyl acrylate), poly(2-ethylhexyl acrylate), butyl acrylate/2-ethylhexyl acrylate copolymers and the like; silicone rubbers such as polyorganosiloxane rubbers; butadiene-acrylic composite rubbers; IPN (Interpenetrating Polymer Network) composite rubbers composed of a polyorganosiloxane rubber and a polyalkyl acrylate rubber; styrene-butadiene rubbers; ethylene-α-olefin rubbers such as ethylene-propylene rubbers, ethylene-butene rubbers, ethylene-octene rubbers and the like; ethylene-acrylic rubbers; fluororubbers; and the like. These may be used alone or as a mixture of two or more of them. Among them, polybutadiene rubbers, polyalkyl acrylate rubbers, polyorganosiloxane rubbers, IPN composite rubbers composed of a polyorganosiloxane rubber and a polyalkyl acrylate rubber, and styrene-butadiene rubbers are preferred to improve mechanical properties and surface appearance.

Specific examples of monomer components that can be graft-copolymerized with the rubber components include aromatic vinyl compounds; vinyl cyanate compounds; (meth)acrylic acid ester compounds; (meth)acrylic acid compounds; epoxy-containing (meth)acrylic acid ester compounds such as glycidyl (meth)acrylate; maleimide compounds such as maleimide, N-methylmaleimide and N-phenylmaleimide; α,β-unsaturated carboxylic acid compounds such as maleic acid, phthalic acid and itaconic acid and their anhydrides (e.g., maleic anhydride and the like), etc. These monomer components may be used alone or as a combination of two or more of them. Among them, aromatic vinyl compounds, vinyl cyanate compounds, (meth) acrylic acid ester compounds, and (meth) acrylic acid compounds are preferred to improve mechanical properties and surface appearance, more preferably (meth)acrylic acid ester compounds. Specific examples of (meth)acrylic acid ester compounds include methyl (meth)acrylate, ethyl (meth)acrylate, butyl (meth)acrylate, cyclohexyl (meth)acrylate, octyl (meth)acrylate and the like.

The graft copolymer obtained by copolymerizing a rubber component is preferably a core-shell graft copolymer to improve impact resistance and surface appearance. Among others, especially preferred are core-shell graft copolymers comprising a core layer consisting of at least one rubber component selected from polybutadiene-containing rubbers, polybutyl acrylate-containing rubbers, polyorganosiloxane rubbers, and IPN composite rubbers composed of a polyorganosiloxane rubber and a polyalkyl acrylate rubber, and a shell layer formed by copolymerizing a (meth)acrylic acid ester around it. The core-shell graft copolymer preferably contains 40 % by mass or more, more preferably 60 % by mass or more of the rubber component. Further, it preferably contains 10 % by mass or more of (meth) acrylic acid. It should be noted that the core-shell as used herein covers the concept widely encompassing compounds obtained by graft polymerization of a rubber component around a core-forming part though the core layer and the shell layer may not necessarily be definitely demarcated.

Preferred specific examples of these core-shell graft copolymers include methyl methacrylate-butadiene-styrene copolymers (MBS), methyl methacrylate-acrylonitrile-butadiene-styrene copolymers (MABS), methyl methacrylate-butadiene copolymers (MB), methyl methacrylate-acrylic rubber copolymers (MA), methyl methacrylate-acrylic rubber-styrene copolymers (MAS), methyl methacrylate-acrylic/butadiene rubber copolymers, methyl methacrylate-acrylic/butadiene rubber-styrene copolymers, methyl methacrylate-(acrylic/silicone IPN rubber) copolymers, styrene-ethylene-butadiene-styrene copolymers and the like. Such rubber polymers may be used alone or as a combination of two or more of them.

The amount of the elastomer contained in the thermoplastic resin composition of the present invention is preferably 0.1 to 40 % by weight, more preferably 0.5 to 25 % by weight, even more preferably 1 to 10 % by weight.

### <Talc>

The thermoplastic resin composition of the present invention may further comprise a talc. In the present invention, the incorporation of talc can improve dimensional stability and product appearance, and also improve the plating properties of resin molded articles so that the resin molded articles can be successfully plated even if the LDS additive is added in smaller amounts. Talc may be used after the talc has been surface-treated with at least one of compounds selected from polyorganohydrogen siloxanes and organopolysiloxanes. In this case, the amount of the siloxane compounds deposited on talc is preferably 0.1 to 5 % by weight talc.

The amount of talc contained in the thermoplastic resin composition of the present invention is preferably 0.01 to 10 parts by weight, more preferably 0.05 to 8 parts by weight, even more preferably 0.5 to 4 parts by weight per 100 parts by weight of the thermoplastic resin compositions. When talc has been surface-treated with a siloxane compound, the amount of talc surface-treated with the siloxane compound should preferably fall within the ranges defined above.

### <Mold release agent>

The thermoplastic resin composition of the present invention may further comprise a mold release agent. The mold release agent is mainly used to improve productivity during molding of the resin composition. Mold release agents include, for example, aliphatic carboxylic acid amides, aliphatic carboxylic acids, esters of aliphatic carboxylic acids and alcohols, aliphatic hydrocarbon compounds having a number average molecular weight of 200 to 15000, polysiloxane silicone oils and the like. Among these mold release agents, carboxylic acid amide compounds are especially preferred.

Aliphatic carboxylic acid amides include, for example, compounds obtained by a dehydration reaction of a higher aliphatic monocarboxylic acid and/or polybasic acid with a diamine.

Higher aliphatic monocarboxylic acids preferably include saturated aliphatic monocarboxylic acids and hydroxycarboxylic acids containing 16 or more carbon atoms such as palmitic acid, stearic acid, behenic acid, montanic acid, 12-hydroxystearic acid and the like.

Polybasic acids include, for example, aliphatic dicarboxylic acids such as malonic acid, succinic acid, adipic acid, sebacic acid, pimelic acid and azelaic acid; aromatic dicarboxylic acids such as phthalic acid and terephthalic acid; alicyclic dicarboxylic acids such as cyclohexanedicarboxylic acid, cyclohexylsuccinic acid and the like.

Diamines include, for example, ethylenediamine, 1,3-diaminopropane, 1,4-diaminobutane, hexamethylenediamine, m-xylylenediamine, tolylenediamine, p-xylylenediamine, phenylenediamine, isophoronediamine and the like.

Carboxylic acid amide compounds preferably include compounds obtained by polycondensing stearic acid, sebacic acid and ethylenediamine, more preferably compounds obtained by polycondensing 2 moles of stearic acid, 1 mole of sebacic acid and 2 moles of ethylenediamine. Further, bisamide compounds obtained by reacting a diamine with an aliphatic carboxylic acid such as N,N'-methylenebisstearic acid amide or N,N'-ethylenebisstearic acid amide as well as dicarboxylic acid amide compounds such as N,N'-dioctadecylterephthalic acid amide can also be preferably used.

Aliphatic carboxylic acids include, for example, saturated or unsaturated aliphatic mono-, di- or tricarboxylic acids. The aliphatic carboxylic acids here also include alicyclic carboxylic acids. Among them, preferred aliphatic carboxylic acids are mono- or dicarboxylic acids containing 6 to 36 carbon atoms, more preferably saturated aliphatic monocarboxylic acids containing 6 to 36 carbon atoms. Specific example of such aliphatic carboxylic acids include palmitic acid, stearic acid, caproic acid, capric acid, lauric acid, arachic acid, behenic acid, lignoceric acid, cerotic acid, melissic acid, tetratriacontanoic acid, montanic acid, adipic acid, azelaic acid, etc.

Aliphatic carboxylic acids that can be used in esters of aliphatic carboxylic acids and alcohols include, for example, the aliphatic carboxylic acids listed above. Alcohols include, for example, saturated or unsaturated mono- or polyalcohols. These alcohols may be substituted by a substituent such as a fluorine atom or an aryl group. Among them, saturated mono- or polyalcohols containing 30 or less carbon atoms are preferred, more preferably saturated aliphatic or alicyclic monoalcohols or saturated aliphatic polyalcohols containing 30 or less carbon atoms.

Specific examples of such alcohols include octanol, decanol, dodecanol, stearyl alcohol, behenyl alcohol, ethylene glycol, diethylene glycol, glycerol, pentaerythritol, 2,2-dihydroxyperfluoropropanol, neopentylene glycol, ditrimethylolpropane, dipentaerythritol and the like.

Specific examples of esters of aliphatic carboxylic acids and alcohols include beeswax (a mixture containing myricyl palmitate as a major component), stearyl stearate, behenyl behenate, stearyl behenate, glyceryl monopalmitate, glyceryl monostearate, glyceryl distearate, glyceryl tristearate, pentaerythritol monopalmitate, pentaerythritol monostearate, pentaerythritol distearate, pentaerythritol tristearate, pentaerythritol tetrastearate and the like.

Aliphatic hydrocarbons having a number average molecular weight of 200 to 15,000 include, for example, liquid paraffin, paraffin waxes, microcrystalline waxes, polyethylene waxes, Fischer-Tropsch waxes, α-olefin oligomers containing 3 to 12 carbon atoms and the like. It should be noted that the aliphatic hydrocarbons here also include alicyclic hydrocarbons. Preferably, the aliphatic hydrocarbons have a number average molecular weight of 5,000 or less.

The amount of the mold release agent contained is typically 0.001 parts by weight or more, preferably 0.01 parts by weight or more, and typically 2 parts by weight or less, preferably 1.5 parts by weight or less per 100 parts by weight of the total of the thermoplastic resin and the glass fiber. When the mold release agent is contained at 0.001 parts by weight or more per 100 parts by weight of the total of the thermoplastic resin and the glass fiber, releasability can be improved. When the mold release agent is contained at 2 parts by weight or less per 100 parts by weight of the total of the thermoplastic resin and the glass fiber, a decrease in hydrolysis resistance can be prevented and mold contamination during injection molding can also be prevented.

### <Other additives>

The thermoplastic resin composition of the present invention may further comprise various additives so far as the advantages of the present invention are not affected. Such additives include titanium oxides, alkalis, heat stabilizers, light stabilizers, antioxidants, UV absorbers, dyes/pigments, fluorescent brightening agents, anti-dripping agents, antistatic agents, anti-fogging agents, lubricants, anti-blocking agents, flow improvers, plasticizers, dispersants, antibacterial agents and the like. These components may be used alone or as a combination of two or more of them.

### <Method for manufacturing the thermoplastic resin composition>

Any methods can be employed for the method for manufacturing the thermoplastic resin composition of the present invention. For example, a method comprises mixing a thermoplastic resin, an LDS additive and a glass fiber by using a mixing means such as a V-blender to prepare a batch blending, and then melting/kneading the batch in a vented extruder to pelletize the batch. An alternative method is a two-step kneading process comprising thoroughly mixing the components and the like except for the glass fiber in advance, then melting/kneading the mixture in a vented extruder to prepare pellets, then mixing the pellets with the glass fiber, and finally melting/kneading the mixture in the vented extruder.

Still another process comprises thoroughly mixing the components and the like except for the glass fiber in a V-blender or the like to prepare a mixture in advance and feeding this mixture from a first shoot of a vented twin-screw extruder while feeding the glass fiber from a second shoot in the midway of the extruder and melting/kneading the mixture of all components to pelletize the mixture.

The screw layout in the kneading zone of the extruder preferably comprises an upstream element for promoting kneading and a downstream element capable of increasing pressure.

Elements for promoting kneading include forward kneading disc elements, neutral kneading disc elements, wide kneading disc elements, and forward mixing screw elements and the like.

The heating temperature during melting/kneading can be typically selected from the range of 180 to 360°C as appropriate. If the temperature is too high, decomposition gases may be readily released to cause opacification. Thus, the screw layout should desirably be chosen by taking into account shear heating and the like. Further, antioxidants or heat stabilizers may be used to inhibit decomposition during kneading and a subsequent molding process.

The method for manufacturing a resin molded article is not specifically limited, and any molding techniques commonly adopted for thermoplastic resin composition can be employed. Examples of such techniques include injection molding, ultra-high speed injection molding, injection compression molding, two-color molding, gas-assisted or other hollow molding, molding techniques using thermally insulated molds, molding techniques using rapidly heated molds, expansion molding (including the use of supercritical fluids), insert molding, IMC (In-Mold Coating) molding techniques, extrusion molding, sheet molding, heat molding, rotational molding, laminate molding, press molding, blow molding and the like. Further, molding techniques using hot runner systems can also be used.

### <Method for manufacturing the resin molded article having a plated layer>

Next, the method for manufacturing the resin molded article having a plated layer of the present invention will be explained, specifically a method for plating a surface of a resin molded article obtained by molding the thermoplastic resin composition of the present invention will be explained with reference to Figure 1.

Figure 1 is a schematic diagram showing a process for plating the surface of a resin molded article 1 by the laser direct structuring technology. In Figure 1, the resin molded article 1 is shown as a flat substrate, but may not be necessarily a flat substrate and instead a resin molded article having a partially or totally curved surface. Further, the resin molded article 1 may not be an end product, but includes various parts.

The resin molded article 1 in the present invention is preferably a part for portable electronic devices. The part for portable electronic devices has not only high impact resistance and rigidity but also excellent heat resistance as well as low anisotropy and low warpage so that the resin molded article is very effective as an internal structure and a chassis for electronic organizers, PDAs such as hand-held computers and electronic databook; pagers, cell phones, PHS phones and the like. In particular, the resin molded article is suitable for use as a flat part for portable electronic devices when the molded article has an average thickness of 1.2 mm or less excluding ribs (and, for example, 0.4 mm or more, though the lower limit is not specifically defined), and it is especially suitable for use as a chassis.
Referring again to Figure 1, the resin molded article 1 is irradiated with a laser beam 2 in the process for preparing a resin molded article having a plated layer of the present invention.

The source of the laser beam 2 is not specifically limited, and can be appropriately selected from known lasers such as YAG lasers, excimer lasers, electromagnetic radiation and the like, especially preferably YAG lasers. Further, the wavelength of the laser beam 2 is not specifically limited, either. A preferred wavelength range of the laser beam 2 is 200 nm to 1200 nm, especially preferably 800 to 1200 nm.

Once the resin molded article 1 is irradiated with the laser beam 2, the resin molded article 1 is activated only in the region 3 irradiated with the laser beam 2. A plating solution 4 is applied to the resin molded article 1 in the activated state. The plating solution 4 is not specifically limited, and known plating solutions can be widely employed, preferably plating solutions containing a metal component such as copper, nickel, gold, silver or palladium, more preferably copper.

The method by which the plating solution 4 is applied to the resin molded article 1 is not specifically limited either, but involves, for example, placing the article into a liquid containing the plating solution. After the plating solution has been applied to the resin molded article 1, a plated layer 5 is formed only on the region irradiated with the laser beam 2.

According to the processes of the present invention, circuits can be formed at distances of 1 mm or less, even 150 µm or less from each other (and, for example, 30 µm or more though the lower limit is not specifically defined). Such circuits are preferably used as antennas for portable electronic devices. Thus, an example of a preferred embodiment of the resin molded article 1 of the present invention is a resin molded article having a plated layer for use as a part for portable electronic devices wherein the plated layer has performance as an antenna.

Additionally, references can be made to the descriptions in JP-A2011-219620, JP-A2011-195820, JP-A2011-178873, JP-A2011-168705, and JP-A2011-148267.

### EXAMPLES

The present invention will further be detailed below referring to Examples. However, the scope of the present invention should not be construed to be limited by Examples below.

### <Thermoplastic resin>

### <Preparation example>

### (Synthesis of a polyamide (PAMP10))

In a reaction vessel under a nitrogen atmosphere, sebacic acid was melted by heating and then the temperature was raised to 235°C while a diamine mixture of p-xylylenediamine (from MITSUBISHI GAS CHEMICAL COMPANY, INC.) and m-xylylenediamine (from MITSUBISHI GAS CHEMICAL COMPANY, INC.) in a molar ratio of 3:7 was gradually added dropwise under pressure (0.35Mpa) while stirring the contents until the molar ratio of diamine to sebacic acid reached about 1:1. After completion of the dropwise addition, the reaction was continued for 60 minutes to control the amount of components having a molecular weight of 1,000 or less. After completion of the reaction, the contents were collected in the form of strands and pelletized in a pelletizer to give a polyamide hereinafter referred to as "PAMP10".

### <LDS additives>

Black 1G: A copper-chromium oxide (CuCr₂O₄ having a Mohs hardness of 5.5 to 6.0 from Shepherd Color Japan, Inc.).

CP5C: An antimony-doped tin oxide (containing 95% by weight of a tin oxide, 5% by weight of an antimony oxide, 0.02% by weight of a lead oxide, and 0.004% by weight of a copper oxide) (from Keeling & Walker).

### <Glass fibers>

03T-296GH: A glass fiber (E-glass having a tensile modulus of elasticity of 72GPa) (from Nippon Electric Glass Co., Ltd.).

S-glass (having a tensile modulus of elasticity of 86 GPa and containing 65% by weight of SiO₂, 25% by weight of Al₂O₃, and 0.001 to 0.01% by weight of B (boron)).

### <Elastomer>

SEBS: FT1901GT (from Kraton Performance Polymers, Inc.).

### <Alkali>

Ca(OH)₂.

### <Talc>

Talc: Micron White 5000S (from Hayashi-Kasei Co., Ltd.).

### <Mold release agent>

CS8CP (from NITTO KASEI KOGYO K.K.).

### <Compounds>

Various components were weighed in the compositions shown in the tables below, and all components excluding the glass fibers were blended in a tumbler and introduced into a twin-screw extruder (TEM26SS from TOSHIBA MACHINE CO., LTD.) from the rear ends of the screws and melted, and then each glass fiber was supplied from a side feeder to prepare resin pellets. The extruder was operated at a temperature setting of 280°C.

### <Preparation of ISO tensile test specimens>

The pellets obtained by the preparation process described above were dried at 80°C for 5 hours, and then injection-molded using an injection molding machine (100T) from FANUC Corporation to form ISO tensile test specimens (having a thickness of 4mm) under conditions of a cylinder temperature of 280°C and a mold temperature of 130°C.

Injection velocity: Injection velocity was set in such a manner that the flow rate of the resin calculated from the sectional area of the center zone of each ISO tensile test specimen equaled 300mm/s. The velocity/pressure switch-over point to the holding phase was adjusted at approximately 95% of filling. The holding phase lasted 25 seconds at 500kgf/cm², i.e., a relatively high pressure without flashing.

### <Flexural strength and flexural modulus of elasticity>

The ISO tensile test specimens (having a thickness of 4mm) described above were used to determine their flexural strength (expressed in MPa) and flexural modulus of elasticity (expressed in GPa) at a temperature of 23°C according to ISO178.

### <Charpy impact strength>

The ISO tensile test specimens (having a thickness of 4mm) obtained by the method described above were used to determine their Charpy notched impact strength and Charpy unnotched impact strength under conditions of 23°C according to ISO179-1 or ISO179-2. The results are shown in Table 1 below.

### <Plating appearance>

Each resin composition was molded by filling each of the resin composition into the cavity of a mold of 60 x 60mm having a thickness of 2mm from a fan gate having a width of 60mm and a thickness of 1.5mm at a resin temperature of 280°C and a mold temperature of 110°C. The gate portion was cut off to give a plating test specimen.

An area of 10 x 10mm of the plating test specimen obtained was irradiated using the laser irradiation system VMcl from Trumpf (a YAG laser with a wavelength of 1064nm and a maximum output power of 15W) at an output power of 40%, a frequency of 60kHz, and a scanning speed of 2m/s. This was followed by a plating process in the electroless plating bath ENPLATE LDS CU-400 PC from Enthone at 48°C. Plating performance was visually determined from the thickness of the layer of copper deposited in 20 minutes.

Evaluation was based on the following criteria. The results are shown in Table 1.
○: Good appearance (a thick plated layer has been formed as proved by a deep copper color).
Δ: A plated layer has been formed, though it is somewhat thin (acceptable for practical uses).
x: No plated layer has been formed.

**[Table 1]**

| | | | Example 1 | Comparative example 1 | Comparative example 2 |
|---|---|---|---|---|---|
| Thermoplastic resin | PAMP10 | Parts by weight | 100 | 100 | 100 |
| LDS additive | Black1G | | 12.1 | 12.1 | |
| Glass fiber | 03T-296GH | | | 80.5 | 80.5 |
| | S-glass | | 80.5 | | |
| Elastomer | FT1901GT | | 6 | 6 | 6 |
| Talc | MW5000S | | 2 | 2 | 2 |
| Mold release agent | CS8CP | | 0.6 | 0.6 | 0.6 |
| Evaluation result | Flexural strength (MPa) | | 269 | 214 | 296 |
| | Flexural modulus of elasticity (GPa) | | 12.9 | 12.3 | 11.6 |
| | Charpy impact strength | notched(kJ/m²) | 8.1 | 3.5 | 13.1 |
| | | unnotched(kJ/m²) | 57 | 32 | 74 |
| | Plating appearance | | ○ | ○ | × |

**[Table 2]**

| | | | Reference Example 2 | Reference Example 3 | Comparative example 3 | Comparative example 4 | Comparative example 5 |
|---|---|---|---|---|---|---|---|
| Thermoplastic resin | PAMP10 | Parts by mass | 100 | 100 | 100 | 100 | 100 |
| LDS additive | CP5C | | 12.1 | 11.3 | 11.3 | 15.7 | 12.1 |
| Glass fiber | S-glass | | 80.5 | 75.3 | | | |
| | 03T-296GH | | | | 75.3 | 78.3 | 81.0 |
| Elastomer | FT1901GT | | 6 | | | | |
| Alkali | Ca(OH)₂ | | | 0.6 | 0.6 | 0.6 | 0.6 |
| Talc | MW5000S | | 2 | 1 | 1 | 1 | 8 |
| Mold release agent | CS8CP | | 0.6 | 0.6 | 0.6 | 0.6 | 0.6 |
| Evaluation result | Flexural strength (MPa) | | 255 | 264 | 170 | 178 | 171 |
| | Flexural modulus of elasticity (GPa) | | 13.1 | 13.8 | 11.9 | 12.0 | 12.8 |
| | Charpy impact strength | notched (kJ/m²) | 7.9 | 7.5 | 4.3 | 4.4 | 4.6 |
| | | unnotched (kJ/m²) | 54 | 52 | 32 | 31 | 31 |
| | Plating appearance | | ○ | ○ | ○ | ○ | ○ |

The tables above show that the thermoplastic resin compositions of the present invention were excellent in all of the flexural strength, the flexural modulus of elasticity, the charpy impact strength and the plating properties of the resulting resin molded articles. However, the compositions using a glass fiber which is out of the scope of the present invention (Comparative examples 1 to 5) were poor in mechanical strength. A composition containing no LDS additive (Comparative example 2) showed high mechanical strength, but failed to be plated.

As has been described above, the thermoplastic resin compositions obtained by the present invention were shown to be excellent in all of the flexural strength, the flexural modulus of elasticity, the charpy impact strength and the plating properties of the resulting resin molded articles. Thus, it was shown that the present invention makes it possible to provide thermoplastic resin compositions from which are obtained resin molded articles having high mechanical strength (the flexural strength, the flexural modulus of elasticity and the charpy impact strength (notched and unnotched)) while retaining the plating properties (plating appearance) of the resin molded articles.

### SYMBOL LEGEND

1: Resin molded article; 2: Laser beam; 3: Laser-irradiated region; 4: Plating solution; 5: Plated layer.

## Claims

1. A thermoplastic resin composition comprising a thermoplastic resin, and 1 to 30 parts by weight of a laser direct structuring additive and 10 to 200 parts by weight of a glass fiber per 100 parts by weight of the thermoplastic resin, wherein the glass fiber comprises SiO₂ and Al₂O₃ in a proportion of 60 to 70 % by weight of SiO₂ and 20 to 30 % by weight of Al₂O_{3,} wherein the laser direct structuring additive comprises a copper-chromium oxide.

2. The thermoplastic resin composition according to claim 1, wherein the laser direct structuring additive has a Mohs hardness of 5.5 or more.

3. The thermoplastic resin composition according to any one of claims 1 to 2, wherein the glass fiber has a tensile modulus of elasticity of 80GPa or more.

4. The thermoplastic resin composition according to any one of claims 1 to 3, wherein the glass fiber comprises S-glass.

5. The thermoplastic resin composition according to any one of claims 1 to 4, wherein the thermoplastic resin is a polyamide resin.

6. A resin molded article obtained by molding the thermoplastic resin composition according to any one of claims 1 to 5.

7. The resin molded article according to claim 6, further comprising a plated layer on a surface.

8. The resin molded article according to claim 6 or 7, which is a part for portable electronic devices.

9. The resin molded article according to claim 7 or 8, wherein the plated layer has performance as an antenna.

10. A method for manufacturing a resin molded article having a plated layer, comprising irradiating a surface of a resin molded article obtained by molding the thermoplastic resin composition according to any one of claims 1 to 5 with a laser beam, and then applying a metal to form a plated layer.

11. The method for manufacturing a resin molded article having a plated layer according to claim 10, wherein the plated layer is a copper plated layer.

12. A method for manufacturing a part for portable electronic devices, comprising a method for manufacturing a resin molded article having a plated layer according to claim 10 or 11.

## Patentansprüche

1. Thermoplastische Harzzusammensetzung umfassend ein thermoplastisches Harz und 1 bis 30 Gewichtsteile eines laserdirektstrukturierten Zusatzmittels und 10 bis 200 Gewichtsteile einer Glasfaser pro 100 Gewichtsteile des thermoplastischen Harzes, wobei die Glasfaser SiO₂ und Al₂O₃ in einem Verhältnis von 60 bis 70 Gewichts-% SiO₂ und 20-30 Gewichts-% Al₂O₃ umfasst, wobei das laserdirektstrukturierte Zusatzmittel ein Kupfer-Chromoxid umfasst.

2. Thermoplastische Harzzusammensetzung nach Anspruch 1, wobei das laserdirektstrukturierte Zusatzmittel eine Mohshärte von 5,5 oder mehr aufweist.

3. Thermoplastische Harzzusammensetzung nach irgendeinem der Ansprüche 1 bis 2, wobei die Glasfaser einen Zugelastizitätsmodul von 80 GPa oder mehr aufweist.

4. Thermoplastische Harzzusammensetzung nach irgendeinem der Ansprüche 1 bis 3, wobei die Glasfaser S-Glas umfasst.

5. Thermoplastische Harzzusammensetzung nach irgendeinem der Ansprüche 1 bis 4, wobei das thermoplastische Harz ein Polyamidharz ist.

6. Ein Harzformteil, erhalten der durch Formen der thermoplastischen Harzzusammensetzung nach irgendeinem der Ansprüche 1 bis 5.

7. Das Harzformteil nach Anspruch 6, ferner eine plattierte Schicht auf einer Oberfläche umfassend.

8. Das Harzformteil nach Anspruch 6 oder 7, das ein Teil für tragbare elektronische Vorrichtungen ist.

9. Das Harzformteil nach Anspruch 7 oder 8, wobei die plattierte Schicht ein Leistungsvermögen als Antenne aufweist.

10. Verfahren für die Herstellung eines Harzformteils, das eine plattierte Schicht aufweist, umfassend das Bestrahlen einer Oberfläche eines Harzformteils, erhalten durch Formen der thermoplastischen Harzzusammensetzung nach irgendeinem der Ansprüche 1 bis 5 mit einem Laserstrahl und dann Auftragen eines Metalls zum Bilden einer plattierten Schicht.

11. Verfahren für die Herstellung eines Harzformteils, das eine plattierte Schicht aufweist nach Anspruch 10, wobei die plattierte Schicht eine kupferplattierte Schicht ist.

12. Verfahren für die Herstellung eines Teils für tragbare elektronische Vorrichtungen, umfassend ein Verfahren für die Herstellung eines Harzformteils, das eine plattierte Schicht aufweist nach Anspruch 10 oder 11.

## Revendications

1. Composition de résine thermoplastique comprenant une résine thermoplastique, et de 1 à 30 parties en poids d'un additif utilisé dans la structuration directe par laser et de 10 à 200 parties en poids d'une fibre de verre pour 100 parties en poids de la résine thermoplastique, dans laquelle la fibre de verre comprend SiO₂ et Al₂O₃ dans une proportion comprise de 60 à 70 % en poids de SiO₂ et de 20 à 30 % en poids de Al₂O_{3,} dans laquelle l'additif utilisé dans la structuration directe par laser comporte un oxyde de cuivre chrome.

2. Composition de résine thermoplastique selon la revendication 1, dans laquelle l'additif utilisé dans la structuration directe par laser possède une dureté de Mohs de 5,5, ou plus.

3. Composition de résine thermoplastique selon la revendication 1 ou la revendication 2, dans lequel la fibre de verre possède un module d'élasticité en traction 80 GPa, ou plus.

4. Composition de résine thermoplastique selon l'une quelconque des revendications 1 à 3, dans laquelle la fibre de verre comprend du verre S.

5. Composition de résine thermoplastique selon l'une quelconque des revendications 1 à 4, dans laquelle la résine thermoplastique est une résine de polyamide.

6. Article moulé de résine obtenu par le moulage de la composition de résine thermoplastique selon l'une quelconque des revendications 1 à 5.

7. Article moulé de résine selon la revendication 6, comprenant en outre une couche plaquée sur une surface.

8. Article moulé de résine selon la revendication 6 ou la revendication 7, qui constitue une partie pour des dispositifs électroniques portables.

9. Article moulé de résine selon la revendication 7 ou la revendication 8, dans lequel la couche plaquée présente une performance en tant qu'antenne.

10. Procédé de fabrication d'un article moulé de résine possédant une couche plaquée, comprenant l'irradiation d'une surface d'un article moulé de résine obtenu par le moulage de la composition de résine thermoplastique selon l'une quelconque des revendications 1 à 5 en utilisant un faisceau laser, et ensuite l'application d'un métal pour former une couche plaquée.

11. Procédé de fabrication d'un article moulé de résine possédant une couche plaquée selon la revendication 10, dans lequel la couche plaquée est une couche plaquée de cuivre.

12. Procédé de fabrication d'une partie pour des dispositifs électroniques portables, comprenant un procédé de fabrication d'un article moulé de résine possédant une couche plaquée selon la revendication 10 ou la revendication 11.
